# EUROPEAN PATENT SPECIFICATION

(11) **EP 4 597 135 B1**
(45) Date of publication and mention of the grant of the patent: **04.11.2026**
(21) Application number: 25154690.9
(22) Date of filing: 29.01.2025
(51) Int. Cl.: G01R 31/378, G01R 31/382, G01R 31/3842, G01R 31/385, G01R 31/387, H02J 7/00, H04R 25/00, H02J 7/82

(54) **A METHOD FOR ESTIMATING A STATE OF CHARGE FOR A HEARING AID**
VERFAHREN ZUR SCHÄTZUNG EINES LADEZUSTANDS FÜR EIN HÖRGERÄT
PROCÉDÉ D'ESTIMATION D'UN ÉTAT DE CHARGE POUR UNE PROTHÈSE AUDITIVE

(30) Priority: 05.02.2024 EP 24155783
(43) Date of publication of application: 06.08.2025
(60) Divisional application: 26196781.4 / 4 826 956
(73) Proprietor: Oticon A/S, 2765 Smørum (DK)
(72) Inventor: CHRISTENSEN, Jess, DK-2765 Smørum (DK); SIGURDSSON, Atli Gilbert, DK-2765 Smørum (DK)
(74) Representative: Demant

(56) References cited:
- EP-B1- 3 253 076
- CN-A- 117 330 967
- KR-A- 20060 052 227
- US-A1- 2010 036 626
- US-A1- 2019 075 404
- US-A1- 2020 003 844
- US-A1- 2022 038 827
- US-A1- 2022 187 382
- US-A1- 2023 010 213
- US-B2- 11 124 072
- US-B2- 8 004 243
- US-B2- 8 264 203

## Description

### TECHNICAL FIELD

The present disclosure relates to the field of hearing aids. In particular, the present disclosure relates to a method for estimating a state of charge for a hearing aid.

### BACKGROUND

The state of charge is used to determine the battery level of a hearing aid, and therefore to provide the battery level of the hearing aid to the user.

It is known to determine the state of charge of the hearing aid during a discharging state of the hearing aid, using a voltage model that can be predetermined and/or updated.

However, using such a voltage model during a charging state of the hearing aid or when changing from the charging state to the discharging state or from the discharging state to the charging state leads to an inaccurate estimation of the state of charge.

There is therefore a need for a more precise solution for determining the state of charge of a hearing aid.

US2023/010213A1 discloses a method for estimating a state of charge for a hearing aid comprising a rechargeable battery.

### SUMMARY

In an aspect of the present disclosure, a method for estimating a state of charge for a hearing aid comprising a rechargeable battery is provided.

The method comprises determining a value of the state of charge based on a weighted combination of a first estimated value of the state of charge determined using a voltage model and a second estimated value of the state of charge determined by tracking a flow of charge or energy of the battery.

The combination of a first weight of the first estimated value and a second weight of the second estimated value correspond to a maximum weight.

The determining of the first estimated value of the state of charge comprises determining whether the battery is in a charging state or a discharging state.

The determining of the first estimated value of the state of charge comprises, when the battery is in the discharging state, using the voltage model and a battery voltage to determine the first estimated value of the state of charge. The determining of the first estimated value of the state of charge comprises, when the battery is in the charging state, using the voltage model and a modelled voltage potential difference between charging and discharging.

Tracking the flow of charge or the flow of energy of the battery allows improving the accuracy of the estimation of the state of charge, particularly in certain situations, such as when changing from the charging state of the battery to the discharging state, or changing from the discharging state of the battery to the charging state.

The weighted combination therefore allows accurately determining the state of charge in all phases of battery operation.

The determining of the first estimated value of the state of charge based on the voltage model can enable a more improved (e.g., accurate) estimation of the state of charge.

In particular, by using the voltage model (e.g., a discharge curve) and the battery voltage for determining the first estimated value of the state of charge when the battery is in the discharging stage as well as by using the voltage model and the modelled voltage potential difference between charging and discharging for determining the first estimated value of the state of charge when the battery is in the discharging stage, the estimation of the state of charge can be vastly improved. In other words, the usage of the voltage model and the model translating charge to discharge allow such improved estimation of the state of charge.

Embodiments of the present disclosure can advantageously provide an inherent consistency between the charging and the discharging predictions of the first estimated value of the state of charge by basing the determination of the first estimated value on the voltage model (e.g., on a learned curve).

In an example, the method further comprises:
- determining the first estimated value of the state of charge using a voltage model, and/or
- determining the second estimated value of the state of charge by tracking flow of charge or energy of the battery.

In an example, the voltage potential difference is modelled as a voltage increase caused by charge current flowing through a resistor and an additional offset accounting for redistribution effects occurring after charging.

In an example, the first estimated value of the state of charge is determined using the formula: $SoCV = \left\{\begin{matrix}f _ learn \left(Vbat\right) , & if discharging \\ f _ learn \left(Vbat-i_charge∗R_charge-Alpha∗V_relax\right) , & if charging\end{matrix}\right.$ wherein:
- SoCV is the first estimated value of the state of charge,
- f_learn is the voltage model,
- Vbat is the battery voltage,
- i_charge is a charge current flowing into the battery,
- R_charge is a modelled charge resistance
- Alpha is a predetermined value, and
- V_relax is another predetermined value, modelling the additional offset.

Such formula may be seen as a model translating charge to discharge.

Embodiment of the present disclosure can enable a lower memory footprint by determining estimated value of the state of charge in such a manner as one curve needs to be persisted in a memory. Furthermore, the system complexity can be lowered since learning a charging curve may be challenging in view of its dependence on parameters like temperature and/or start condition. By basing the determination of the first estimated value on a learned curve (e.g., on the voltage model), an inherent consistency between the charging and the discharging predictions of the first estimated value of the state of charge can be provided.

Alpha can depend on the battery voltage, the value of Alpha being typically higher at very low voltages: $\begin{matrix}SoCV \\ = \left\{\begin{matrix}f _ learn \left(Vbat\right) , & if discharging \\ f _ learn \left(Vbat-i_charge∗R_charge-Alpha\left(Vbat\right)∗V_relax\right) , & if charging\end{matrix}\right.\end{matrix}$

Alpha therefore offers the ability to the value V_relax, to account for variations in the magnitude of redistribution at different voltage levels.

In a simple implementation Alpha can also be set to 1, thus ignoring variations and providing a cruder approximation.

V_relax is typically a constant and corresponds to a battery voltage drop when the charge current which was applied to the battery is no longer being applied.

In an example, the second estimated value of the state of charge is determined using one of the following formulas: $SoCC \left(t\right) = SoC \left(0\right) + {\int }_{0}^{t} i _ bat dt$ or $SoCC \left(t\right) = SoC \left(0\right) + {\int }_{0}^{t} i _ bat ∗ Vbat dt$ wherein:
- SoCC is the second estimated value of the state of charge,
- SoC(0) is the value of the state of charge after a change from the charging state to the discharging state or moving from the discharging state to the charging state, and
- i_bat is the battery current,
- t is the time since a change of state, and
- Vbat is the battery voltage.

The battery current can be determined using the formula: $i _ bat = \left\{\begin{matrix}i _ charge & during charging \\ - i _ discharge & during discharging\end{matrix}\right.$ wherein:
- i_bat is the battery current,
- i_charge is the charge current flowing into the battery during charging,
- i_discharge is the discharge current being drawn from the battery during discharging.

In an example, when an ending condition is met, the second weight is decreased towards a minimum weight and/or the first weight is increased towards a maximum weight.

In an example, when a change in state condition is met and the ending condition is not met, the second weight is set to be substantially equal to the maximum weight and/or the first weight is set to be substantially equal to the minimum weight.

In another example, the method further comprises, when a change in state condition is met and the ending condition is not met:
- determining whether the battery is fully charged or not fully charged,
- if the battery is fully charged, setting the second weight to be substantially equal to the maximum weight, and
- if the battery is not fully charged, setting the first weight to be substantially equal to the maximum weight.

In an example, when the change in state condition is not met and the ending condition is not met, the second weight is continuously decreased and/or the first weight is continuously increased.

In another aspect of the present disclosure, another method for estimating a state of charge for a hearing aid comprising a rechargeable battery is provided.

The method may comprise determining a value of the state of charge based on a first estimated value of the state of charge, determined using a voltage model.

The determining of the first estimated value of the state of charge may comprise:
- determining whether the battery is in a charging state or a discharging state,
- when the battery is in the discharging state, using the voltage model and a battery voltage to determine the first estimated value of the state of charge,
- when the battery is in the charging state, using the voltage model and a modelled voltage potential difference between charging and discharging.

In a further aspect of the present disclosure, a hearing aid is provided. The hearing aid comprises:
- an input unit configured to receive an acoustical signal and convert the acoustical signal into an input signal,
- a signal processor configured to process the input signal with a hearing loss profile of the user,
- an output unit configured to emit the processed signal with the hearing loss profile into the ear of the user, and
- a rechargeable battery.

Moreover, the signal processor is configured to perform one of the methods as described above, in the 'detailed description of embodiments', and in the claims.

The hearing aid may be adapted to provide a frequency dependent gain and/or a level dependent compression and/or a transposition (with or without frequency compression) of one or more frequency ranges to one or more other frequency ranges, e.g. to compensate for a hearing impairment of a user. The hearing aid comprises the signal processor for enhancing the input signals and providing a processed signal.

The hearing aid comprises the output unit for providing a stimulus perceived by the user as an acoustic signal based on the processed signal. The output unit may a vibrator of a bone conducting hearing aid. The output unit may comprise an output transducer. The output transducer may comprise a receiver (loudspeaker) for providing the stimulus as an acoustic signal to the user (e.g. in an acoustic (air conduction based) hearing aid). The output transducer may comprise a vibrator for providing the stimulus as mechanical vibration of a skull bone to the user (e.g. in a bone-attached or bone-anchored hearing aid). The output unit may (additionally or alternatively) comprise a (e.g. wireless) transmitter for transmitting sound picked up-by the hearing aid to another device, e.g. a far-end communication partner (e.g. via a network, e.g. in a telephone mode of operation, or in a headset configuration).

The hearing aid comprises the input unit for providing an electric input signal representing sound. The input unit may comprise an input transducer, e.g. a microphone, for converting an input sound to an electric input signal. The input unit may comprise a wireless receiver for receiving a wireless signal comprising or representing sound and for providing an electric input signal representing said sound.

The wireless receiver and/or transmitter may e.g. be configured to receive and/or transmit an electromagnetic signal in the radio frequency range (3 kHz to 300 GHz). The wireless receiver and/or transmitter may e.g. be configured to receive and/or transmit an electromagnetic signal in a frequency range of light (e.g. infrared light 300 GHz to 430 THz, or visible light, e.g. 430 THz to 770 THz).

The hearing aid may comprise a directional microphone system adapted to spatially filter sounds from the environment, and thereby enhance a target acoustic source among a multitude of acoustic sources in the local environment of the user wearing the hearing aid. The directional system may be adapted to detect (such as adaptively detect) from which direction a particular part of the microphone signal originates. This can be achieved in various different ways as e.g. described in the prior art. In hearing aids, a microphone array beamformer is often used for spatially attenuating background noise sources. The beamformer may comprise a linear constraint minimum variance (LCMV) beamformer. Many beamformer variants can be found in literature. The minimum variance distortionless response (MVDR) beamformer is widely used in microphone array signal processing. Ideally the MVDR beamformer keeps the signals from the target direction (also referred to as the look direction) unchanged, while attenuating sound signals from other directions maximally. The generalized sidelobe canceller (GSC) structure is an equivalent representation of the MVDR beamformer offering computational and numerical advantages over a direct implementation in its original form.

Most sound signal sources (except the user's own voice) are located far way from the user compared to dimensions of the hearing aid, e.g. a distance d_{mic} between two microphones of a directional system. A typical microphone distance in a hearing aid is of the order 10 mm. A *minimum* distance of a sound source of interest to the user (e.g. sound from the user's mouth or sound from an audio delivery device) is of the order of 0.1 m (> 10 d_{mic}). For such minimum distances, the hearing aid (microphones) would be in the acoustic near-field of the sound source and a difference in level of the sound signals impinging on respective microphones may be significant. A *typical* distance for a communication partner is more than 1 m (>100 d_{mic}). The hearing aid (microphones) would be in the acoustic far-field of the sound source and a difference in level of the sound signals impinging on respective microphones is insignificant. The difference in *time of arrival* of sound impinging in the direction of the microphone axis (e.g. the front or back of a normal hearing aid) is ΔT= d_{mic}/v_{sound}=0.01/343 [s]=29 µs, where v_{sound} is the speed of sound in air at 20°C (343 m/s).

The hearing aid may comprise antenna and transceiver circuitry allowing a wireless link to an entertainment device (e.g. a TV-set), a communication device (e.g. a telephone), a wireless microphone, a separate (external) processing device, or another hearing aid, etc. The hearing aid may thus be configured to wirelessly receive a direct electric input signal from another device. Likewise, the hearing aid may be configured to wirelessly transmit a direct electric output signal to another device. The direct electric input or output signal may represent or comprise an audio signal and/or a control signal and/or an information signal.

In general, a wireless link established by antenna and transceiver circuitry of the hearing aid can be of any type. The wireless link may be a link based on near-field communication, e.g. an inductive link based on an inductive coupling between antenna coils of transmitter and receiver parts. The wireless link may be based on far-field, electromagnetic radiation. Preferably, frequencies used to establish a communication link between the hearing aid and the other device is below 70 GHz, e.g. located in a range from 50 MHz to 70 GHz, e.g. above 300 MHz, e.g. in an ISM range above 300 MHz, e.g. in the 900 MHz range or in the 2.4 GHz range or in the 5.8 GHz range or in the 60 GHz range (ISM=Industrial, Scientific and Medical, such standardized ranges being e.g. defined by the International Telecommunication Union, ITU). The wireless link may be based on a standardized or proprietary technology. The wireless link may be based on Bluetooth technology (e.g. Bluetooth Low-Energy technology, e.g. LE audio), or Ultra WideBand (UWB) technology.

The hearing aid is a portable (i.e. configured to be wearable) device, and comprises a rechargeable battery. The hearing aid may also comprise a battery circuitry comprising a current accumulator (also called a Coulomb counter or a fuel gauge). The hearing aid may comprise a temperature sensor.

The hearing aid may e.g. be a low weight, easily wearable, device, e.g. having a total weight less than 100 g, such as less than 20 g, such as less than 5 g.

The hearing aid may comprise a "forward" (or 'signal') path for processing an audio signal between an input and an output of the hearing aid. A signal processor may be located in the forward path. The signal processor may be adapted to provide a frequency dependent gain according to a user's particular needs (e.g. hearing impairment). The hearing aid may comprise an 'analysis' path comprising functional components for analyzing signals and/or controlling processing of the forward path. Some or all signal processing of the analysis path and/or the forward path may be conducted in the frequency domain, in which case the hearing aid comprises appropriate analysis and synthesis filter banks. Some or all signal processing of the analysis path and/or the forward path may be conducted in the time domain.

An analogue electric signal representing an acoustic signal may be converted to a digital audio signal in an analogue-to-digital (AD) conversion process, where the analogue signal is sampled with a predefined sampling frequency or rate fₛ, fₛ being e.g. in the range from 8 kHz to 48 kHz (adapted to the particular needs of the application) to provide digital samples xₙ (or x[n]) at discrete points in time tₙ (or n), each audio sample representing the value of the acoustic signal at tₙ by a predefined number N_{b} of bits, N_{b} being e.g. in the range from 1 to 48 bits, e.g. 24 bits. Each audio sample is hence quantized using N_{b} bits (resulting in 2^{Nb} different possible values of the audio sample). A digital sample x has a length in time of 1/fₛ, e.g. 50 µs, for *fₛ* = 20 kHz. A number of audio samples may be arranged in a time frame. A time frame may comprise 64 or 128 audio data samples. Other frame lengths may be used depending on the practical application.

The hearing aid may comprise an analogue-to-digital (AD) converter to digitize an analogue input (e.g. from an input transducer, such as a microphone) with a predefined sampling rate, e.g. 20 kHz. The hearing aids may comprise a digital-to-analogue (DA) converter to convert a digital signal to an analogue output signal, e.g. for being presented to a user via an output transducer.

The hearing aid, e.g. the input unit, and or the antenna and transceiver circuitry may comprise a transform unit for converting a time domain signal to a signal in the transform domain (e.g. frequency domain or Laplace domain, Z transform, wavelet transform, etc.). The transform unit may be constituted by or comprise a TF-conversion unit for providing a time-frequency representation of an input signal. The time-frequency representation may comprise an array or map of corresponding complex or real values of the signal in question in a particular time and frequency range. The TF conversion unit may comprise a filter bank for filtering a (time varying) input signal and providing a number of (time varying) output signals each comprising a distinct frequency range of the input signal. The TF conversion unit may comprise a Fourier transformation unit (e.g. a Discrete Fourier Transform (DFT) algorithm, or a Short Time Fourier Transform (STFT) algorithm, or similar) for converting a time variant input signal to a (time variant) signal in the (time-)frequency domain. The frequency range considered by the hearing aid from a minimum frequency fₘᵢₙ to a maximum frequency fₘₐₓ may comprise a part of the typical human audible frequency range from 20 Hz to 20 kHz, e.g. a part of the range from 20 Hz to 12 kHz. Typically, a sample rate fₛ is larger than or equal to twice the maximum frequency fₘₐₓ, fₛ ≥ 2fₘₐₓ. A signal of the forward and/or analysis path of the hearing aid may be split into a number *NI* of frequency bands (e.g. of uniform width), where *NI* is e.g. larger than 5, such as larger than 10, such as larger than 50, such as larger than 100, such as larger than 500, at least some of which are processed individually. The hearing aid may be adapted to process a signal of the forward and/or analysis path in a number *NP* of different frequency channels *(NP* ≤ *NI*)*.* The frequency channels may be uniform or non-uniform in width (e.g. increasing in width with frequency), overlapping or non-overlapping.

The hearing aid may be configured to operate in different modes, e.g. a normal mode and one or more specific modes, e.g. selectable by a user, or automatically selectable. A mode of operation may be optimized to a specific acoustic situation or environment, e.g. a communication mode, such as a telephone mode. A mode of operation may include a low-power mode, where functionality of the hearing aid is reduced (e.g. to save power), e.g. to disable wireless communication, and/or to disable specific features of the hearing aid.

The hearing aid may comprise a number of detectors configured to provide status signals relating to a current physical environment of the hearing aid (e.g. the current acoustic environment), and/or to a current state of the user wearing the hearing aid, and/or to a current state or mode of operation of the hearing aid. Alternatively or additionally, one or more detectors may form part of an *external* device in communication (e.g. wirelessly) with the hearing aid. An external device may e.g. comprise another hearing aid, a remote control, and audio delivery device, a telephone (e.g. a smartphone), an external sensor, etc.

One or more of the number of detectors may operate on the full band signal (time domain). One or more of the number of detectors may operate on band split signals ((time-) frequency domain), e.g. in a limited number of frequency bands.

The number of detectors may comprise a level detector for estimating a current level of a signal of the forward path. The detector may be configured to decide whether the current level of a signal of the forward path is above or below a given (L-)threshold value. The level detector operates on the full band signal (time domain). The level detector operates on band split signals ((time-) frequency domain).

The hearing aid may comprise a voice activity detector (VAD) for estimating whether or not (or with what probability) an input signal comprises a voice signal (at a given point in time). A voice signal may in the present context be taken to include a speech signal from a human being. It may also include other forms of utterances generated by the human speech system (e.g. singing). The voice activity detector unit may be adapted to classify a current acoustic environment of the user as a VOICE or NO-VOICE environment. This has the advantage that time segments of the electric microphone signal comprising human utterances (e.g. speech) in the user's environment can be identified, and thus separated from time segments only (or mainly) comprising other sound sources (e.g. artificially generated noise). The voice activity detector may be adapted to detect as a VOICE also the user's own voice. Alternatively, the voice activity detector may be adapted to exclude a user's own voice from the detection of a VOICE.

The hearing aid may comprise an own voice detector for estimating whether or not (or with what probability) a given input sound (e.g. a voice, e.g. speech) originates from the voice of the user of the system. A microphone system of the hearing aid may be adapted to be able to differentiate between a user's own voice and another person's voice and possibly from NON-voice sounds.

The number of detectors may comprise a movement detector, e.g. an acceleration sensor. The movement detector may be configured to detect movement of the user's facial muscles and/or bones, e.g. due to speech or chewing (e.g. jaw movement) and to provide a detector signal indicative thereof.

The hearing aid may comprise a classification unit configured to classify the current situation based on input signals from (at least some of) the detectors, and possibly other inputs as well. In the present context 'a current situation' may be taken to be defined by one or more of
a) the physical environment (e.g. including the current electromagnetic environment, e.g. the occurrence of electromagnetic signals (e.g. comprising audio and/or control signals) intended or not intended for reception by the hearing aid, or other properties of the current environment than acoustic);
b) the current acoustic situation (input level, feedback, etc.), and
c) the current mode or state of the user (movement, temperature, cognitive load, etc.);
d) the current mode or state of the hearing aid (program selected, time elapsed since last user interaction, etc.) and/or of another device in communication with the hearing aid.

The classification unit may be based on or comprise a neural network, e.g. a recurrent neural network, e.g. a trained neural network.

The hearing aid may comprise an acoustic (and/or mechanical) feedback control (e.g. suppression) or echo-cancelling system. Adaptive feedback cancellation has the ability to track feedback path changes over time. It is typically based on a linear time invariant filter to estimate the feedback path, but its filter weights are updated over time. The filter update may be calculated using stochastic gradient algorithms, including some form of the Least Mean Square (LMS) or the Normalized LMS (NLMS) algorithms. They both have the property to minimize the error signal in the mean square sense with the NLMS additionally normalizing the filter update with respect to the squared Euclidean norm of some reference signal.

The hearing aid may further comprise other relevant functionality for the application in question, e.g. compression, noise reduction, etc.

The hearing aid is e.g. a hearing instrument adapted for being located at the ear or fully or partially in the ear canal of a user, or a headset, an earphone, an ear protection device or a combination thereof. A hearing system may comprise a speakerphone (comprising a number of input transducers (e.g. a microphone array) and a number of output transducers, e.g. one or more loudspeakers, and one or more audio (and possibly video) transmitters e.g. for use in an audio conference situation), e.g. comprising a beamformer filtering unit, e.g. providing multiple beamforming capabilities.

In an aspect, use of a hearing aid as described above, in the 'detailed description of embodiments' and in the claims, is moreover provided. Use may be provided in a system comprising one or more hearing aids, e.g. in handsfree telephone systems, teleconferencing systems (e.g. including a speakerphone), public address systems, karaoke systems, classroom amplification systems, etc.

It is intended that some or all of the structural features of the device described above, in the 'detailed description of embodiments' or in the claims can be combined with embodiments of the methods, when appropriately substituted by a corresponding process and vice versa. Embodiments of the methods have the same advantages as the corresponding devices.

In an aspect, a tangible computer-readable medium (a data carrier) storing a computer program comprising program code means (instructions) for causing a data processing system (a computer) to perform (carry out) at least some (such as a majority or all) of the (steps of the) methods described above, in the 'detailed description of embodiments' and in the claims, when said computer program is executed on the data processing system is furthermore provided by the present application.

By way of example, and not limitation, such computer-readable media can comprise RAM, ROM, EEPROM, CD-ROM or other optical disk storage, magnetic disk storage or other magnetic storage devices, or any other medium that can be used to carry or store desired program code in the form of instructions or data structures and that can be accessed by a computer. Disk and disc, as used herein, includes compact disc (CD), laser disc, optical disc, digital versatile disc (DVD), floppy disk and Blu-ray disc where disks usually reproduce data magnetically, while discs reproduce data optically with lasers. Other storage media include storage in DNA (e.g. in synthesized DNA strands). Combinations of the above should also be included within the scope of computer-readable media. In addition to being stored on a tangible medium, the computer program can also be transmitted via a transmission medium such as a wired or wireless link or a network, e.g. the Internet, and loaded into a data processing system for being executed at a location different from that of the tangible medium.

A computer program (product) comprising instructions which, when the program is executed by a computer, cause the computer to carry out (steps of) the methods described above, in the 'detailed description of embodiments' and in the claims is furthermore provided by the present disclosure.

In an aspect, a data processing system comprising a processor and program code means for causing the processor to perform at least some (such as a majority or all) of the steps of the method described above, in the 'detailed description of embodiments' and in the claims is furthermore provided by the present application.

In a further aspect, a hearing system comprising a hearing aid as described above, in the 'detailed description of embodiments', and in the claims, and an auxiliary device is moreover provided.

The hearing system may be adapted to establish a communication link between the hearing aid and the auxiliary device to provide that information (e.g. control and status signals, possibly audio signals) can be exchanged or forwarded from one to the other.

The auxiliary device may be constituted by or comprise a remote control, a smartphone, or other portable or wearable electronic device, such as a smartwatch or the like.

The auxiliary device may be constituted by or comprise a remote control for controlling functionality and operation of the hearing aid(s). The function of a remote control may be implemented in a smartphone, the smartphone possibly running an APP allowing to control the functionality of the audio processing device via the smartphone (the hearing aid(s) comprising an appropriate wireless interface to the smartphone, e.g. based on Bluetooth or some other standardized or proprietary scheme).

The auxiliary device may be constituted by or comprise an audio gateway device adapted for receiving a multitude of audio signals (e.g. from an entertainment device, e.g. a TV or a music player, a telephone apparatus, e.g. a mobile telephone or a computer, e.g. a PC, a wireless microphone, etc.) and adapted for selecting and/or combining an appropriate one of the received audio signals (or combination of signals) for transmission to the hearing aid.

The auxiliary device may be constituted by or comprise another hearing aid. The hearing system may comprise two hearing aids adapted to implement a binaural hearing system, e.g. a binaural hearing aid system.

The auxiliary device may be constituted by or comprise a charger, the charger being configured to charge the rechargeable battery of the hearing aid, the charger comprising an integrated circuit charger.

In a further aspect, a non-transitory application, termed an APP, is furthermore provided by the present disclosure. The APP comprises executable instructions configured to be executed on an auxiliary device to implement a user interface for a hearing aid or a hearing system described above in the 'detailed description of embodiments', and in the claims. The APP may be configured to run on cellular phone, e.g. a smartphone, or on another portable device allowing communication with said hearing aid or said hearing system.

### Definitions:

**In** the present context, a hearing aid, e.g. a hearing instrument, refers to a device, which is adapted to improve, augment and/or protect the hearing capability of a user by receiving acoustic signals from the user's surroundings, generating corresponding audio signals, possibly modifying the audio signals and providing the possibly modified audio signals as audible signals to at least one of the user's ears. Such audible signals may e.g. be provided in the form of acoustic signals radiated into the user's outer ears and/or acoustic signals transferred as mechanical vibrations to the user's inner ears through the bone structure of the user's head and/or through parts of the middle ear.

The hearing aid may be configured to be worn in any known way, e.g. as a unit arranged behind the ear with a tube leading radiated acoustic signals into the ear canal or with an output transducer, e.g. a loudspeaker, arranged close to or in the ear canal, as a unit entirely or partly arranged in the pinna and/or in the ear canal, as a unit, e.g. a vibrator, attached to a fixture implanted into the skull bone, etc. The hearing aid may comprise a single unit or several units communicating (e.g. acoustically, electrically or optically) with each other. The loudspeaker may be arranged in a housing together with other components of the hearing aid, or may be an external unit in itself (possibly in combination with a flexible guiding element, e.g. a dome-like element).

A hearing aid may be adapted to a particular user's needs, e.g. a hearing impairment. A configurable signal processing circuit of the hearing aid may be adapted to apply a frequency and level dependent compressive amplification of an input signal. A customized frequency and level dependent gain (amplification or compression) may be determined in a fitting process by a fitting system based on a user's hearing data, e.g. an audiogram, using a fitting rationale (e.g. adapted to speech). The frequency and level dependent gain may e.g. be embodied in processing parameters, e.g. uploaded to the hearing aid via an interface to a programming device (fitting system), and used by a processing algorithm executed by the configurable signal processing circuit of the hearing aid.

A 'hearing system' refers to a system comprising one or two hearing aids, and a 'binaural hearing system' refers to a system comprising two hearing aids and being adapted to cooperatively provide audible signals to both of the user's ears. Hearing systems or binaural hearing systems may further comprise one or more 'auxiliary devices', which communicate with the hearing aid(s) and affect and/or benefit from the function of the hearing aid(s). Such auxiliary devices may include at least one of a charger, a remote control, a remote microphone, an audio gateway device, an entertainment device, e.g. a music player, a wireless communication device, e.g. a mobile phone (such as a smartphone) or a tablet or another device, e.g. comprising a graphical interface. Hearing aids, hearing systems or binaural hearing systems may e.g. be used for compensating for a hearing-impaired person's loss of hearing capability, augmenting or protecting a normal-hearing person's hearing capability and/or conveying electronic audio signals to a person. Hearing aids or hearing systems may e.g. form part of or interact with public-address systems, active ear protection systems, handsfree telephone systems, car audio systems, entertainment (e.g. TV, music playing or karaoke) systems, teleconferencing systems, classroom amplification systems, etc.

The invention is set out in the appended set of claims.

### BRIEF DESCRIPTION OF DRAWINGS

The aspects of the disclosure may be best understood from the following detailed description taken in conjunction with the accompanying figures. The figures are schematic and simplified for clarity, and they just show details to improve the understanding of the claims, while other details are left out. Throughout, the same reference numerals are used for identical or corresponding parts. The individual features of each aspect may each be combined with any or all features of the other aspects. These and other aspects, features and/or technical effect will be apparent from and elucidated with reference to the illustrations described hereinafter in which:
FIG. 1 schematically shows a hearing aid according to an exemplary embodiment of the invention,
FIG. 2 illustrates a flow diagram, showing the steps of a method for estimating a state of charge, according to an exemplary embodiment of the invention,
FIG. 3 illustrates a flow diagram, showing the steps of another method for estimating a state of charge, according to an exemplary embodiment of the invention,
FIG. 4 schematically shows a voltage model that can be used to determine the first estimated value, and
FIG. 5 schematically shows a charge voltage, a discharge voltage and a charge current of the hearing aid of FIG. 1, as a function of time.

The figures are schematic and simplified for clarity, and they just show details which are essential to the understanding of the disclosure, while other details are left out. Throughout, the same reference signs are used for identical or corresponding parts.

Further scope of applicability of the present disclosure will become apparent from the detailed description given hereinafter. However, it should be understood that the detailed description and specific examples, while indicating preferred embodiments of the disclosure, are given by way of illustration only. Other embodiments may become apparent to those skilled in the art from the following detailed description.

### DETAILED DESCRIPTION OF EMBODIMENTS

The detailed description set forth below in connection with the appended drawings is intended as a description of various configurations. The detailed description includes specific details for the purpose of providing a thorough understanding of various concepts. However, it will be apparent to those skilled in the art that these concepts may be practiced without these specific details. Several aspects of the apparatus and methods are described by various blocks, functional units, modules, components, circuits, steps, processes, algorithms, etc. (collectively referred to as "elements"). Depending upon particular application, design constraints or other reasons, these elements may be implemented using electronic hardware, computer program, or any combination thereof.

The electronic hardware may include micro-electronic-mechanical systems (MEMS), integrated circuits (e.g. application specific), microprocessors, microcontrollers, digital signal processors (DSPs), field programmable gate arrays (FPGAs), programmable logic devices (PLDs), gated logic, discrete hardware circuits, printed circuit boards (PCB) (e.g. flexible PCBs), and other suitable hardware configured to perform the various functionality described throughout this disclosure, e.g. sensors, e.g. for sensing and/or registering physical properties of the environment, the device, the user, etc. Computer program shall be construed broadly to mean instructions, instruction sets, code, code segments, program code, programs, subprograms, software modules, applications, software applications, software packages, routines, subroutines, objects, executables, threads of execution, procedures, functions, etc., whether referred to as software, firmware, middleware, microcode, hardware description language, or otherwise.

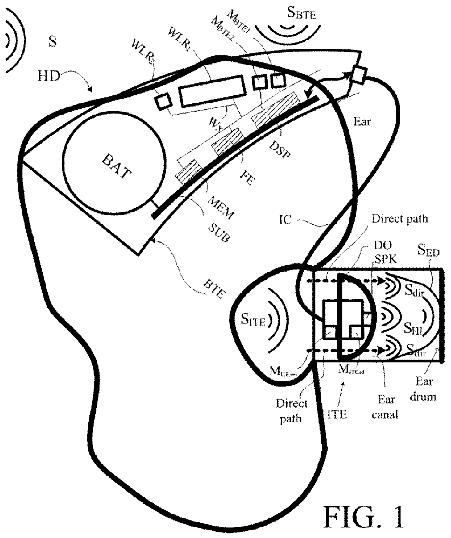

The present disclosure relates to the field of hearing aids, and relates to a method for estimating a state of charge for a hearing aid such as the hearing aid described with reference to FIG 1.

FIG. 1 shows a hearing aid HD according to an exemplary embodiment of the invention. The hearing aid is adapted to provide a frequency dependent gain and/or a level dependent compression and/or a transposition (with or without frequency compression) of one or more frequency ranges to one or more other frequency ranges, e.g. to compensate for a hearing impairment of a user.

In this example, the hearing aid HD, is of a particular style (sometimes termed receiver-in-the ear, or RITE, style) comprising a BTE-part adapted for being located at or behind an ear of a user, and an ITE-part adapted for being located in or at an ear canal of the user's ear. The BTE-part and the ITE-part are connected (e.g. electrically connected) by a connecting element IC and internal wiring in the ITE- and BTE-parts (cf. e.g. wiring Wx in the BTE-part). The connecting element may alternatively be fully or partially constituted by a wireless link between the BTE- and ITE-parts.

The BTE part comprises an input unit comprising two (first) input transducers (e.g. microphones) M_{BTE1}, M_{BTE2}, each for providing an (first) electric input audio signal representative of an input sound signal S_{BTE} (originating from a sound field S around the hearing device). The input unit may further comprise two wireless receivers WLR₁, WLR₂ (or transceivers) for providing respective directly received auxiliary audio and/or control input signals (and/or allowing transmission of audio and/or control signals to other devices, e.g. to another hearing aid, or to a remote control or processing device, or a telephone). The hearing aid HD comprises a substrate SUB whereon a number of electronic components are mounted, including a memory MEM, e.g. storing different hearing aid programs (e.g. parameter settings defining such programs, or parameters of algorithms) and/or hearing aid configurations, e.g. input source combinations M_{BTE1}, M_{BTE2}, M_{ITE,env}, M_{ITE,ed}, WLR₁, WLR₂, e.g. optimized for a number of different listening situations. In a specific mode of operation, one or more directly received auxiliary electric signals may be used together with one or more of the electric input signals from the microphones to provide a beamformed signal provided by applying appropriate complex weights to (at least some of) the respective signals, e.g. to provide an enhanced target signal to the user (or an estimate of the user's own voice to another application, e.g. a communication partner, or a voice control interface).

The substrate SUB further comprises a configurable signal processor DSP, e.g. a digital audio signal processor, e.g. including a processor for applying a frequency and level dependent gain, e.g. providing hearing loss compensation, beamforming, noise reduction, filter bank functionality, and other digital functionality of a hearing device. The configurable signal processor DSP is adapted to access the memory MEM. The configurable signal processor DSP is further configured to process one or more of the electric input audio signals and/or one or more of the directly received auxiliary audio input signals, based on a currently selected (activated) hearing aid program/parameter setting (e.g. either automatically selected, e.g. based on one or more sensors, or selected based on inputs from a user interface). The mentioned functional units (as well as other components) may be partitioned in circuits and components according to the application in question (e.g. with a view to size, power consumption, analogue vs. digital processing, acceptable latency, etc.), e.g. integrated in one or more integrated circuits, or as a combination of one or more integrated circuits and one or more separate electronic components (e.g. inductor, capacitor, etc.). The configurable signal processor DSP provides a processed audio signal, which is intended to be presented to a user. The substrate further comprises a front-end IC FE for interfacing the configurable signal processor (DSP) to the input and output transducers, etc., and typically comprising interfaces between analogue and digital signals (e.g. interfaces to microphones and/or loudspeaker(s)). The input and output transducers may be individual separate components, or integrated (e.g. MEMS-based) with other electronic circuitry.

The hearing device HD further comprises an output unit (e.g. an output transducer) providing stimuli perceivable by the user as sound based on a processed audio signal from the processor or a signal derived therefrom. For example, the ITE part comprises the output transducer in the form of a loudspeaker (also termed a 'receiver') SPK for converting an electric signal to an acoustic (air borne) signal, which (when the hearing device is mounted at an ear of the user) is directed towards the ear drum *(Ear drum),* where sound signal S_{ED} is provided. The ITE-part further comprises a guiding element DO, e.g. a dome, for guiding and positioning the ITE-part in the ear canal *(Ear canal)* of the user. The ITE-part may further comprise a further (first) input transducer, e.g. a microphone M_{ITE,env}, facing the environment for providing an electric input audio signal representative of an input sound signal S_{ITE} at the ear canal. The ITE-part may further comprise a further (second) input transducer, e.g. a microphone M_{ITE,ed}, facing the eardrum for providing an (second) electric input audio signal representative of the sound signal (S_{ED} = S_{dir} + S_{HI}) at the eardrum. Propagation of sound S_{ITE} from the environment to a residual volume at the ear drum via direct acoustic paths through the semi-open dome DO are indicated in FIG. 1 by dashed arrows (denoted *Direct path).* The directly propagated sound (indicated by sound fields S_{dir}) is mixed with sound from the hearing aid HD (indicated by sound field S_{HI}) to a resulting sound field S_{ED} at the ear drum. The sound output S_{HI} of the hearing device may (at least in a specific mode of operation) be modified in view of the directly propagated sound from the environment to the ear drum to provide adaptive noise cancellation (ANC) and/or adaptive occlusion control (AOC).

Apart from the (acoustic) output and input transducers, the ITE part may comprise other functional components, e.g. (further) detectors, such as electrodes for picking up signals from the user's body (such as brainwave signals, temperature indications, blood-related parameters, heartbeat indications, muscular vibrations, etc.). Such detectors may include one or more of an electroencephalography (EEG) sensor, an electromyography (EMG) sensor, a movement sensor, a temperature sensor, a photoplethysmography (PPG) sensor, an electrooculography (EOG) sensor, etc.

The electric input signals from first and/or second input transducers M_{BTE1}, M_{BTE2}, M_{ITE,env}, M_{ITE,ed} may be processed in the time domain or in the (time-) frequency domain (or partly in the time domain and partly in the frequency domain as considered advantageous for the application in question).

The hearing aid HD comprises a rechargeable battery BAT, e.g. based on Li-Ion battery technology, e.g. for energizing electronic components of the BTE- and possibly ITE-parts. Moreover, the hearing aid HD may comprise a battery circuitry comprising a current accumulator (also called a Coulomb counter or a fuel gauge).

The BTE-part may comprise a connector (e.g. a DAI or USB connector) for connecting a 'shoe' with added functionality (e.g. an FM-shoe or an extra battery, etc.), or a programming device, or a charger, or a separate processing device, etc., to the hearing aid HD.

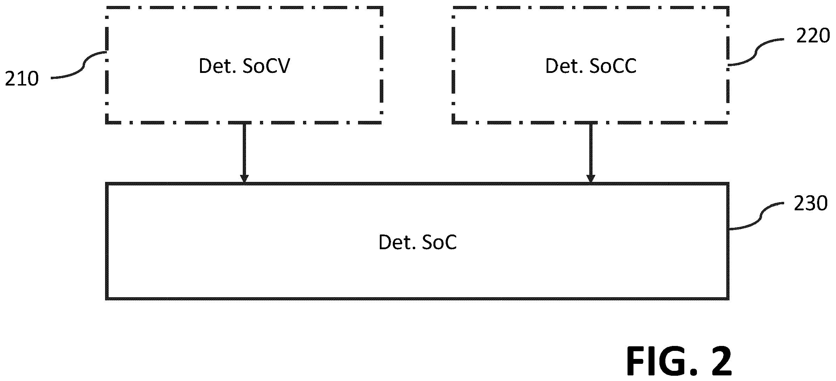

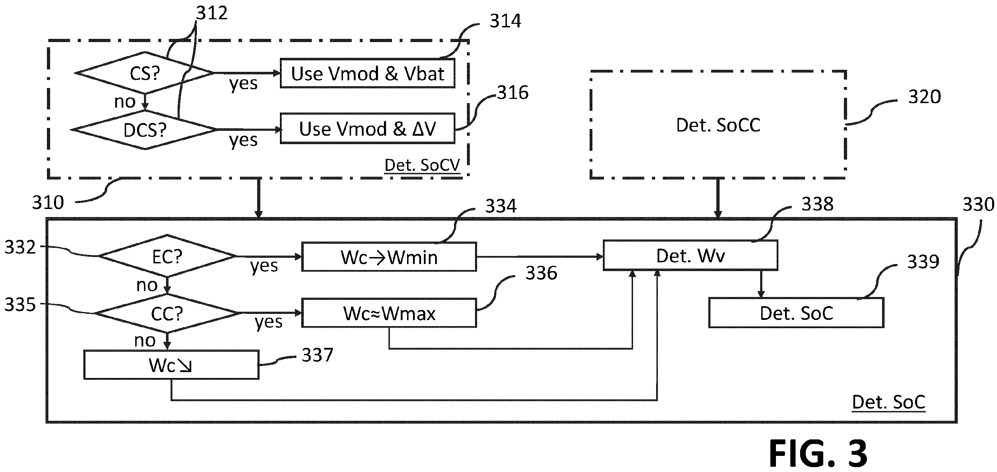

The hearing aid HD is configured to perform at least some of the steps of the method for estimating a state of charge according to the present disclosure, such as the method described with reference to FIG. 2 and the method described with reference to FIG. 3.

**FIG. 2** illustrates a flow diagram, showing the steps of a method for estimating a state of charge, according to an exemplary embodiment of the invention.

The method comprises determining 230 a value of the state of charge SoC based on a weighted combination of a first estimated value SoCV of the state of charge and a second estimated value SoCC of the state of charge.

The first estimated value SoCV of the state of charge is determined using a voltage model. Moreover, the second estimated value SoCC of the state of charge is determined by tracking a flow of charge of the battery BAT, or is determined by tracking a flow of energy of the battery.

Moreover, the combination of a first weight of the first estimated value and a second weight of the second estimated value correspond to a maximum weight.

The method may also comprise determining 210 the first estimated value SoCV of the state of charge using the voltage model and/or determining 220 the second estimated value SoCC of the state of charge by tracking flow of charge or energy of the battery BAT.

**FIG. 3** illustrates a flow diagram, showing the steps of another method for estimating a state of charge, according to an exemplary embodiment of the invention.

The method may comprise determining 310 a first estimated value SoCV of the state of charge using a voltage model.

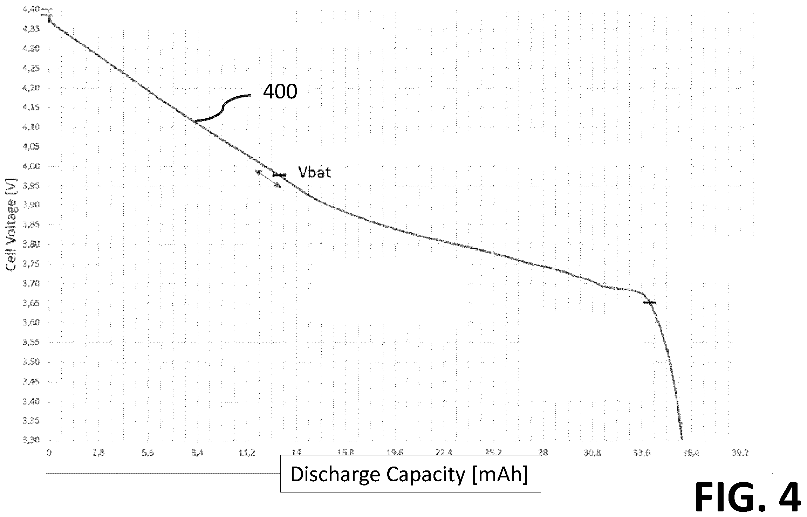

The voltage model is typically a mapping between the battery voltage and the discharge capacity of the battery BAT (also called the discharge charge of the battery), i.e. the charge drawn from the battery BAT or the actual charge stored on the battery BAT. The mapping is for example a predetermined bijective mapping between the battery voltage and the charge drawn from the battery BAT, such as the voltage model of FIG. 4.

FIG. 4 schematically shows a voltage model that can be used to determine the first estimated value SoCV. The voltage model is a discharge curve 400, representing the battery voltage as a function of the discharge capacity, for the battery BAT of the hearing aid HD.

The discharge curve 400 is typically predetermined, as there is a capacity-to-voltage variation across different kinds of battery.

Moreover, the discharge curve 400 can be updated throughout the lifespan of the battery BAT, as there is a capacity-to-voltage variation throughout the lifespan.

For example, an initial predetermined discharge curve, which can be a typical discharge curve for the battery type of the battery BAT, is progressively updated, e.g. using an input from the current accumulator which keeps track of the charge drawn over time, a temperature variation determined using the temperature sensor and a battery voltage that may be determined by an integrated circuit charger of a charger of the hearing aid HD.

The actual charging voltage may be reduced due to temperature. Moreover, the update may be disabled if the temperature is below a temperature threshold such as 15 degrees Celsius, or if the charge or the consumed energy is above a charge threshold after boot (e.g. 0.175mAh), or if the battery voltage is below a voltage threshold (e.g. 3850mV).

The discharge curve of FIG. 4 is a bijective mapping with linear interpolations between voltage levels of the battery voltage and actual charge stored on the battery BAT, from a maximum voltage which is in this example the maximum Li-Ion voltage for the utilized battery type.

If the battery is replaced, the voltage model is typically replaced with a voltage model corresponding to the new battery, e.g. by another initial discharge curve corresponding to the new battery which is then progressively updated.

The voltage model can also be a mapping (example a predetermined bijective mapping) between the battery voltage and the discharge energy of the battery BAT (for example the discharge energy in mWh). Such a mapping can also be predetermined, as there are variations across different kinds of battery, replaced when the battery is replaced, and updated throughout the lifespan of the battery BAT, as there are variations throughout the lifespan. The update can be disabled if the temperature is below a temperature threshold, or if the consumed energy is above an energy threshold after boot, or if the battery voltage is below a voltage threshold.

Returning to the method shown in **FIG. 3****,** determining 310 the first estimated value SoCV of the state of charge may be done differently depending on whether the battery is in a charging state or a discharging state, to take into account a voltage difference and/or a redistribution effect, that may lead to an initial overshooting of the first estimated value SoCV based on voltage when going from charging to discharging, and an initial undershooting when going from discharging to charging.

More specifically, during charging, the voltage is higher than during discharging, due to changes in the electrochemistry and diffusion of lithium ions. Changing state between charging and discharging leads to a redistribution effect involving a slow migration of lithium ions. Redistribution can span several hours impacting the battery voltage. However, most of the redistribution happens in less than an hour, and a significant fraction Alpha occurs almost instantly.

Therefore, determining 310 the first estimated value SoCV of the state of charge may comprise determining 312 whether the battery is in a charging state or a discharging state.

When the battery is in the discharging state, the first estimated value SoCV of the state of charge is determined 314 using the voltage model Vmod and the battery voltage Vbat.

More specifically, the current battery voltage Vbat is obtained, the first estimated value SoCV corresponding to the discharge capacity value obtained using the current battery voltage Vbat and the voltage model Vmod.

When the battery is in the charging state, the first estimated value SoCV of the state of charge is determined 316 using the voltage model Vmod and a modelled voltage potential difference ΔV of the battery voltage between charging and discharging.

The voltage potential difference ΔV is typically modelled as a voltage increase caused by charge current flowing through a resistor and an additional offset accounting for a redistribution effect occurring after charging.

For example, the first estimated value SoCV of the state of charge is determined using the formula: $SoCV = \left\{\begin{matrix}f _ learn \left(Vbat\right) , & if discharging \\ f _ learn \left(Vbat-i_charge∗R_charge-Alpha∗V_relax\right) , & if charging\end{matrix}\right.$ wherein:
- SoCV is the first estimated value of the state of charge,
- f_learn is the voltage model,
- Vbat is the battery voltage,
- i_charge is a charge current flowing into the battery,
- R_charge is a modelled charge resistance
- Alpha is a predetermined value, and
- V_relax is another predetermined value, modelling the additional offset.

In this formula, the voltage potential difference ΔV is modelled by the part *i_charge * R_charge - Alpha * V_relax.*

The additional offset Vrelax is typically constant, and accounts for the voltage drop that occurs after charging complete due to electrochemical redistribution. The additional offset V_relax corresponds to a battery voltage drop when the charge current which was applied to the battery is no longer being applied.

The value Alpha scales the additional offset Vrelax to the amount of voltage drop that happens almost instantly. The value Alpha can additionally scale to account for the variation that occurs due to different battery voltage. The value Alpha may be predetermined and/or fixed.

Alpha can depend on the battery voltage Vbat, the value of Alpha being typically higher at very low voltages: $\begin{matrix}SoCV \\ = \left\{\begin{matrix}f _ learn \left(Vbat\right) , & if discharging \\ f _ learn \left(Vbat-i_charge∗R_charge-Alpha\left(Vbat\right)∗V_relax\right) , & if charging\end{matrix}\right.\end{matrix}$

Alpha therefore offers the ability to scale the value V_relax to account for variations in the magnitude of redistribution at different voltage levels.

In a simple implementation Alpha can also be set to 1, thus ignoring variations and providing a cruder approximation.

A second estimated value SoCC of the state of charge may also be determined 320 by tracking flow of charge of the battery, or by tracking the flow of energy of the battery.

When the battery BAT is in the discharging state, the Coulomb counter is used to track the flow of charge or energy of the battery BAT. For example, when the battery BAT is in the charging state, the flow of charge is determined by integrating, using the Coulomb counter, the current of the integrated circuit charger.

When the flow of charge is tracked, the second estimated value of the state of charge may be determined using the formula: $SoCC \left(t\right) = SoC \left(0\right) + {\int }_{0}^{t} i _ bat dt$ wherein:
- SoCC is the second estimated value of the state of charge,
- SoC(0) is the value of the state of charge after a change from the charging state to the discharging state or moving from the discharging state to the charging state,
- i_bat is the battery current, and
- t is the time since a change of state.

When the flow of energy is tracked, the second estimated value of the state of charge may be determined using the formula: $SoCC \left(t\right) = SoC \left(0\right) + {\int }_{0}^{t} i _ bat ∗ Vbat dt$ wherein:
- SoCC is the second estimated value of the state of charge,
- SoC(0) is the value of the state of charge after a change from the charging state to the discharging state or moving from the discharging state to the charging state,
- i_bat is the battery current,
- t is the time since a change of state, and
- Vbat is the battery voltage.

In both cases, the battery current can be determined using the formula: $i _ bat = \left\{\begin{matrix}i _ charge & during charging \\ - i _ discharge & during discharging\end{matrix}\right.$ wherein:
- i_bat is the battery current,
- i_charge is the charge current flowing into the battery during charging,
- i_discharge is the discharge current being drawn from the battery during discharging.

The method comprises determining 330 a value of the state of charge SoC based on a weighted combination of the first estimated value SoCV of the state of charge and the second estimated value SoCC of the state of charge.

The value of the state of charge SoC may be determined using the formula: $SoC = SoCV * Wv + SoCC * Wc ,$ where Wv = Wmax - Wc, Wmin ≤ Wv ≤ Wmax, and Wmin ≤ Wc ≤ Wmax,
wherein:
- SoS is the state of charge,
- SoCV is the first estimated value of the state of charge,
- Wv is the first weight,
- SoCC is the second estimated value of the state of charge,
- Wc is the second weight,
- Wmin is a minimum weight, and
- Wmax is a maximum weight.

Wmin is e.g. equal to 0 while Wmax is equal to 1 or 100.

Determining 330 the value of the state of charge SoC may comprise determining whether one or more state conditions of the battery BAT are met or not, such as determining 332 whether an ending condition EC is met and/or determining 335 whether a change in state condition CC is met.

The ending condition EC is e.g. the charging is almost done or the shutdown voltage is almost reached.

When the ending condition EC is met, the second weight Wc is decreased or shifted 334 towards the minimum weight Wmin. This allows that the state of charge SoC reaches its maximum value when the charging is complete, and that the state of charge SoC reaches its minimum value when the hearing aid HD shuts down due to the shutdown voltage level.

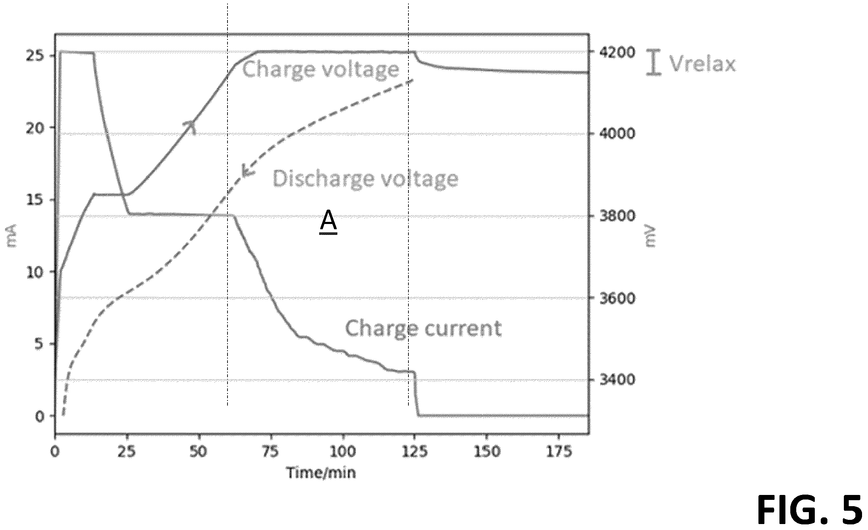

For example, to determine whether the charging is almost done, it is determined whether the charge current is decreasing while the battery voltage is substantially constant, i.e. while the battery is in a constant voltage mode (see area A in **FIG.** 5). When it is determined that the charging is almost done, the second weight Wc is typically decreased 334 as the charge current decreases in the constant voltage mode, and is for example continuously decreased.

To determine whether the shutdown voltage is almost reached, it is determined whether the battery voltage is below a battery voltage threshold, such as a predetermined battery low voltage threshold. When it is determined that the shutdown voltage is almost reached, i.e. when it is determined that the battery voltage is below the battery voltage threshold, the second weight Wc is typically decreased 334, e.g. by applying a linear scale to the second weight Wc while the battery voltage is decreasing between the battery voltage threshold and the shutdown voltage.

The change in state condition CC is a change from the charging state to the discharging state of the battery, or a change from the discharging state to the charging state of the battery.

It is determined 335 whether the change in state condition CC is met, and when the change in state condition CC is met and the ending condition EC is not met, the second weight Wc is typically set 336 to be substantially equal to the maximum weight Wmax.

This allows using the second estimated value SoCC of the state of charge, which allows obtaining a more precise estimation of the state of charge SoC in this case as the counting/tracking of the flow of charge/energy of the battery is used. The initial value SoC(0) used, which is the value of the state of charge just before changing state, ensure consistency in the state of charge reporting when changing state.

When the change in state condition CC is met and the ending condition EC is not met, it can also be determined whether the battery is fully charged or not fully charged. If the battery is fully charged, the second weight Wc can be set 336 to be substantially equal to the maximum weight Wmax, and if the battery is not fully charged, the first weight Wv can be set to be substantially equal to the maximum weight Wmax.

When the change in state condition CC is not met and the ending condition EC is not met, the second weight Wc is continuously decreased 337, typically following the fade of redistribution effect after a potential change in state. For example, the second weight Wc is continuously decreased as a function of the relaxation voltage after charging, and more specifically follows the inverse of the relaxation voltage after charging. The relaxation voltage is the battery voltage decreasing after charging due to the redistribution effect, when the battery is unloaded.

The first weight Wv can be then determined 338 based on the second weight Wc, using the formula Wv = Wmax - Wc.

Of course, instead of determining the second weight Wc at steps 334, 336 or 337, the first weight Wv can be determined. More specifically, when the ending condition EC is met, the first weight Wv is increased towards the maximum weight Wmax, when the change in state condition CC is met and the ending condition EC is not met, the first weight Wv is set 336 to be substantially equal to the maximum weight Wmax, and when the change in state condition CC is not met and the ending condition EC is not met, the first weight Wv is continuously increased 337. The second weight Wc is then determined at step 338 based on the first weight Wv, using the formula Wv = Wmax - Wc.

The value of the state of charge SoC is then determined 339 using the first weight Wv and the first estimated value SoCV and/or the second weight Wc and the second estimated value SoCC.

Steps 332-338 of determining the first weight Wv and/or the second weight Wc may be performed before determining 310 the first estimated value SoCV and/or determining 320 the second estimated value SoCC.

The step of determining 310 the first estimated value SoCV may not be performed when the change in state condition is met, as the first estimated value SoCV may be not taken into account, the associated first weight being substantially equal to zero.

The step of determining 320 the second estimated value SoCC may not be performed when the ending condition is met, as the second estimated value SoCC may be not taken into account, the associated second weight being substantially equal to zero.

The estimated state of charge can be used to determine the battery level of a hearing aid, and therefore to provide the battery level of the hearing aid to the user.

In another embodiment, the step 320 of determining a second estimated value SoCC of the state of charge and the step 330 of determining a value of the state of charge SoC based on a weighted combination of the first estimated value SoCV of the state of charge and the second estimated value SoCC of the state of charge of are not performed. In this embodiment, only the first estimated value SoCV determined at step 310 is used to determine the state of charge SoC. More specifically, when the battery is in the discharging state, the state of charge SoC corresponds to the first estimated value SoCV determined at step 314, and when the battery is in the charging state, the state of charge SoC corresponds to the first estimated value SoCV determined at step 316.

It is intended that the structural features of the devices described above, either in the detailed description and/or in the claims, may be combined with steps of the method, when appropriately substituted by a corresponding process.

As used, the singular forms "a," "an," and "the" are intended to include the plural forms as well (i.e. to have the meaning "at least one"), unless expressly stated otherwise. It will be further understood that the terms "includes," "comprises," "including," and/or "comprising," when used in this specification, specify the presence of stated features, integers, steps, operations, elements, and/or components, but do not preclude the presence or addition of one or more other features, integers, steps, operations, elements, components, and/or groups thereof. It will also be understood that when an element is referred to as being "connected" or "coupled" to another element, it can be directly connected or coupled to the other element, but an intervening element may also be present, unless expressly stated otherwise. Furthermore, "connected" or "coupled" as used herein may include wirelessly connected or coupled. As used herein, the term "and/or" includes any and all combinations of one or more of the associated listed items. The steps of any disclosed method are not limited to the exact order stated herein, unless expressly stated otherwise.

It should be appreciated that reference throughout this specification to "one embodiment" or "an embodiment" or "an aspect" or features included as "may" means that a particular feature, structure or characteristic described in connection with the embodiment is included in at least one embodiment of the disclosure. Furthermore, the particular features, structures or characteristics may be combined as suitable in one or more embodiments of the disclosure. The previous description is provided to enable any person skilled in the art to practice the various aspects described herein. Various modifications to these aspects will be readily apparent to those skilled in the art, within the scope of the invention, which is defined by the appended claims.

## Claims

1. A method for estimating a state of charge for a hearing aid comprising a rechargeable battery, the method comprising:
• determining a value of the state of charge based on a weighted combination of:
• a first estimated value of the state of charge determined using a voltage model and,
• a second estimated value of the state of charge determined by tracking a flow of charge or energy of the battery,
wherein the combination of a first weight of the first estimated value and a second weight of the second estimated value correspond to a maximum weight, **characterised in that**
determining the first estimated value of the state of charge comprises:
• determining whether the battery is in a charging state or a discharging state,
• when the battery is in the discharging state, using the voltage model and a battery voltage to determine the first estimated value of the state of charge,
• when the battery is in the charging state, using the voltage model and a modelled voltage potential difference between charging and discharging.

2. The method according to claim 1, wherein the voltage potential difference is modelled as a voltage increase caused by charge current flowing through a resistor and an additional offset accounting for redistribution effects occurring after charging.

3. The method according to any one of claims 1-2, wherein the first estimated value of the state of charge is determined using the formula: $SoCV = \left\{\begin{matrix}f _ learn \left(Vbat\right) , & if discharging \\ f _ learn \left(Vbat-i_charge∗R_charge-Alpha∗V_relax\right) , & if charging\end{matrix}\right.$ wherein:
• SoCV is the first estimated value of the state of charge,
• f_learn is the voltage model,
• Vbat is the battery voltage,
• i_charge is a charge current flowing into the battery,
• R_charge is a modelled charge resistance
• Alpha is a predetermined value, and
• V_relax is another predetermined value, modelling the additional offset.

4. The method according to any one of claims 1-3, wherein the second estimated value of the state of charge is determined using one of the following formulas: $SoCC \left(t\right) = SoC \left(0\right) + {\int }_{0}^{t} i _ bat dt$ or $SoCC \left(t\right) = SoC \left(0\right) + {\int }_{0}^{t} i _ bat ∗ Vbat dt$ wherein:
• SoCC is the second estimated value of the state of charge,
• SoC(0) is the value of the state of charge after a change from the charging state to the discharging state or moving from the discharging state to the charging state,
• i_bat is the battery current,
• t is the time since a change of state, and
• Vbat is the battery voltage.

5. The method according to any one of claims 1-4, wherein when an ending condition is met, the second weight is decreased towards a minimum weight and/or the first weight is increased towards a maximum weight.

6. The method according to claim 5, wherein when a change in state condition is met and the ending condition is not met, the second weight is set to be substantially equal to the maximum weight and/or the first weight is set to be substantially equal to the minimum weight.

7. The method according to claim 5, further comprising, when a change in state condition is met and the ending condition is not met:
• determining whether the battery is fully charged or not fully charged,
• if the battery is fully charged, setting the second weight to be substantially equal to the maximum weight, and
• if the battery is not fully charged, setting the first weight to be substantially equal to the maximum weight.

8. The method according to claim 5, wherein when the change in state condition is not met and the ending condition is not met, the second weight is continuously decreased and/or the first weight is continuously increased.

9. A hearing aid (HD) configured to compensate a hearing loss of a user wearing the hearing aid, wherein the hearing aid comprises:
an input unit (M_{BTE1}, M_{BTE2}, WLR₁, WLR₂) configured to receive an acoustical signal (S_{BTE}) and convert the acoustical signal into
an input signal,
a signal processor (DSP) configured to process the input signal with a hearing loss profile of the user,
an output unit configured to emit the processed signal with the hearing loss profile into the ear of the user, and a rechargeable battery (BAT),
**characterised in that** the signal processor (DSP) is configured to perform the method according to any of the claims 1 to 8.

10. A system comprising the hearing aid according to claim 9 and a charger configured to charge the rechargeable battery of the hearing aid.

11. A data processing system comprising a processor and program code means for causing the processor to perform all steps of the method according to any one of claims 1-8.

12. A computer program comprising instructions which, when the program is executed by a computer, cause the computer to carry out the method according to any one of claims 1-8.

## Patentansprüche

1. Verfahren zum Schätzen eines Ladezustands für ein Hörgerät, das eine wiederaufladbare Batterie umfasst, wobei das Verfahren Folgendes umfasst:
• Bestimmen eines Werts des Ladezustands auf Grundlage einer gewichteten Kombination von:
• einem ersten geschätzten Wert des Ladezustands, der unter Verwendung eines Spannungsmodells bestimmt wird, und
• einem zweiten geschätzten Wert des Ladezustands, der durch Nachverfolgen eines Ladungs- oder Energieflusses der Batterie bestimmt wird,
wobei die Kombination eines ersten Gewichts des ersten geschätzten Werts und eines zweiten Gewichts des zweiten geschätzten Werts einem maximalen Gewicht entspricht, **dadurch gekennzeichnet, dass** das Bestimmen des ersten geschätzten Werts des Ladezustands Folgendes umfasst:
• Bestimmen, ob sich die Batterie in einem Ladezustand oder einem Entladezustand befindet,
• wenn sich die Batterie in dem Entladezustand befindet, Verwenden des Spannungsmodells und einer Batteriespannung, um den ersten geschätzten Wert des Ladezustands zu bestimmen,
• wenn sich die Batterie in dem Ladezustand befindet, Verwenden des Spannungsmodells und einer modellierten Spannungspotentialdifferenz zwischen Laden und Entladen.

2. Verfahren nach Anspruch 1, wobei die Spannungspotentialdifferenz als eine Spannungserhöhung, die durch einen Ladestrom verursacht wird, der durch einen Widerstand fließt, und einen zusätzlichen Versatz, der Umverteilungseffekte berücksichtigt, die nach dem Laden auftreten, modelliert wird.

3. Verfahren nach einem der Ansprüche 1-2, wobei der erste geschätzte Wert des Ladezustands unter Verwendung der folgenden Formel bestimmt wird: $SoCV = \left\{\begin{matrix}f _ learn \left(Vbat\right) , & falls Entladen \\ f _ learn \left(Vbat-i_charge∗R_charge-Alpha∗V_relax\right) , & falls Laden\end{matrix}\right.$ wobei:
• SoCV der erste geschätzte Wert des Ladezustands ist,
• f_learn das Spannungsmodell ist,
• Vbat die Batteriespannung ist,
• i_charge ein Ladestrom ist, der in die Batterie fließt,
• R_charge ein modellierter Ladungswiderstand ist,
• Alpha ein vorbestimmter Wert ist und
• V_relax ein anderer vorbestimmter Wert ist, der den zusätzlichen Versatz modelliert.

4. Verfahren nach einem der Ansprüche 1-3, wobei der zweite geschätzte Wert des Ladezustands unter Verwendung einer der folgenden Formeln bestimmt wird: $SoCC \left(t\right) = SoC \left(0\right) + {\int }_{0}^{t} i _ bat dt$ oder $SoCC \left(t\right) = SoC \left(0\right) + {\int }_{0}^{t} i _ bat ∗ Vbat dt$ wobei:
• SoCC der zweite geschätzte Wert des Ladezustands ist,
• SoC(0) der Wert des Ladezustands nach einer Änderung von dem Ladezustand in den Entladezustand oder nach einem Übergang von dem Entladezustand in den Ladezustand ist,
• i_bat der Batteriestrom ist,
• t die Zeit seit einem Zustandswechsel ist und
• Vbat die Batteriespannung ist.

5. Verfahren nach einem der Ansprüche 1-4, wobei, wenn eine Endbedingung erfüllt ist, das zweite Gewicht in Richtung eines Mindestgewichts verringert wird und/oder das erste Gewicht in Richtung eines Maximalgewichts erhöht wird.

6. Verfahren nach Anspruch 5, wobei, wenn eine Zustandsänderungsbedingung erfüllt ist und die Endbedingung nicht erfüllt ist, das zweite Gewicht im Wesentlichen gleich dem maximalen Gewicht eingestellt ist und/oder das erste Gewicht im Wesentlichen gleich dem minimalen Gewicht eingestellt ist.

7. Verfahren nach Anspruch 5, ferner umfassend, wenn eine Zustandsänderungsbedingung erfüllt ist und die Endbedingung nicht erfüllt ist:
• Bestimmen, ob die Batterie vollständig aufgeladen oder nicht vollständig aufgeladen ist,
• wenn die Batterie vollständig aufgeladen ist, Einstellen des zweiten Gewichts auf im Wesentlichen gleich dem maximalen Gewicht, und
• wenn die Batterie nicht vollständig aufgeladen ist, Einstellen des ersten Gewichts auf im Wesentlichen gleich dem maximalen Gewicht.

8. Verfahren nach Anspruch 5, wobei, wenn die Zustandsänderungsbedingung nicht erfüllt ist und die Endbedingung nicht erfüllt ist, das zweite Gewicht kontinuierlich verringert wird und/oder das erste Gewicht kontinuierlich erhöht wird.

9. Hörgerät (HD), das dazu konfiguriert ist, einen Hörverlust eines Benutzers, der das Hörgerät trägt, zu kompensieren, wobei das Hörgerät Folgendes umfasst:
eine Eingangseinheit (M_{BTE1'} M_{BTE2'} WLR_{1,} WLR₂), die dazu konfiguriert ist,
ein akustisches Signal (S_{BTE}) zu empfangen und das akustische Signal in ein Eingangssignal umzuwandeln,
einen Signalprozessor (DSP), der dazu konfiguriert ist, das Eingangssignal mit einem Hörverlustprofil des Benutzers zu verarbeiten, wobei eine Ausgangseinheit dazu konfiguriert ist, das verarbeitete Signal mit dem Hörverlustprofil in das Ohr des Benutzers auszusenden,
und eine wiederaufladbare Batterie (BAT),
**dadurch gekennzeichnet, dass** der Signalprozessor (DSP) dazu konfiguriert ist, das Verfahren nach einem der Ansprüche 1 bis 8 durchzuführen.

10. System, umfassend das Hörgerät nach Anspruch 9 und ein Ladegerät, das dazu konfiguriert ist, die wiederaufladbare Batterie des Hörgeräts aufzuladen.

11. Datenverarbeitungssystem, umfassend einen Prozessor und Programmcodemittel, um den Prozessor zu veranlassen, alle Schritte des Verfahrens nach einem der Ansprüche 1-8 durchzuführen.

12. Computerprogramm, das Anweisungen umfasst, die, wenn das Programm von einem Computer ausgeführt wird, den Computer dazu veranlassen, das Verfahren nach einem der Ansprüche 1-8 auszuführen.

## Revendications

1. Procédé d'estimation d'un état de charge pour une prothèse auditive comprenant une batterie rechargeable, le procédé comprenant :
• la détermination d'une valeur de l'état de charge sur la base d'une combinaison pondérée de :
• une première valeur estimée de l'état de charge déterminée à l'aide d'un modèle de tension et,
• une deuxième valeur estimée de l'état de charge déterminée par le suivi d'un flux de charge ou d'énergie de la batterie,
dans lequel la combinaison d'un premier poids de la première valeur estimée et d'un second poids de la deuxième valeur estimée correspond à un poids maximum, **caractérisé en ce que** la détermination de la première valeur estimée de l'état de charge comprend :
• la détermination si la batterie se trouve dans un état de charge ou un état de décharge,
• lorsque la batterie se trouve dans l'état de décharge, l'utilisation du modèle de tension et d'une tension de batterie pour déterminer la première valeur estimée de l'état de charge,
• lorsque la batterie se trouve dans l'état de charge, l'utilisation du modèle de tension et d'une différence de potentiel de tension modélisée entre la charge et la décharge.

2. Procédé selon la revendication 1, dans lequel la différence de potentiel de tension est modélisée comme une augmentation de tension provoquée par le courant de charge circulant à travers une résistance et un décalage supplémentaire tenant compte des effets de redistribution se produisant après la charge.

3. Procédé selon l'une quelconque des revendications 1 à 2, dans lequel la première valeur estimée de l'état de charge est déterminée à l'aide de la formule : $SoCV = \left\{\begin{matrix}f _ learn \left(Vbat\right) , & si décharge \\ f _ learn \left(Vbat-i_charge∗R_charge-Alpha∗V_relax\right) , & si charge\end{matrix}\right.$ dans laquelle :
• SoCV est la première valeur estimée de l'état de charge,
• f_learn est le modèle de tension,
• Vbat est la tension de la batterie,
• i_charge est un courant de charge circulant dans la batterie,
• R_charge est une résistance de charge modélisée
• Alpha est une valeur prédéterminée, et
• V_relax est une autre valeur prédéterminée, modélisant le décalage supplémentaire.

4. Procédé selon l'une quelconque des revendications 1 à 3, dans lequel la deuxième valeur estimée de l'état de charge est déterminée à l'aide de l'une des formules suivantes : $SoCC \left(t\right) = SoC \left(0\right) + {\int }_{0}^{t} i _ bat dt$ ou $SoCC \left(t\right) = SoC \left(0\right) + {\int }_{0}^{t} i _ bat ∗ Vbat dt$ dans lesquelles :
• SoCC est la deuxième valeur estimée de l'état de charge,
• SoC(0) est la valeur de l'état de charge après un changement de l'état de charge à l'état de décharge ou le passage de l'état de décharge à l'état de charge,
• i_bat est le courant de la batterie,
• t est le temps écoulé depuis un changement d'état, et
• Vbat est la tension de la batterie.

5. Procédé selon l'une quelconque des revendications 1 à 4, dans lequel lorsqu'une condition de fin est satisfaite, le second poids est diminué vers un poids minimum et/ou le premier poids est augmenté vers un poids maximum.

6. Procédé selon la revendication 5, dans lequel lorsqu'un changement de condition d'état est satisfait et que la condition de fin n'est pas satisfaite, le second poids est réglé pour être sensiblement égal au poids maximum et/ou le premier poids est réglé pour être sensiblement égal au poids minimum.

7. Procédé selon la revendication 5, comprenant en outre, lorsqu'un changement de condition d'état est satisfait et que la condition de fin n'est pas satisfaite :
• la détermination si la batterie est complètement chargée ou n'est pas complètement chargée,
• si la batterie est complètement chargée, le réglage du second poids pour qu'il soit sensiblement égal au poids maximal, et
• si la batterie n'est pas complètement chargée, le réglage du premier poids pour qu'il soit sensiblement égal au poids maximum.

8. Procédé selon la revendication 5, dans lequel lorsque le changement de condition d'état n'est pas satisfait et que la condition de fin n'est pas satisfaite, le second poids est diminué en continu et/ou le premier poids est augmenté en continu.

9. Prothèse auditive (HD) conçue pour compenser une perte auditive d'un utilisateur portant la prothèse auditive, dans laquelle la prothèse auditive comprend :
une unité d'entrée (M_{BTE1}, M_{BTE2}, WLR_{1,} WLR₂) configurée pour recevoir un signal acoustique (S_{BTE}) et convertir le signal acoustique en un signal d'entrée,
un processeur de signal (DSP) configuré pour traiter le signal d'entrée avec un profil de perte auditive de l'utilisateur,
une unité de sortie configurée pour émettre le signal traité avec le profil de perte auditive dans l'oreille de l'utilisateur,
et une batterie rechargeable (BAT),
**caractérisée en ce que** le processeur de signal (DSP) est configuré pour exécuter le procédé selon l'une quelconque des revendications 1 à 8.

10. Système comprenant la prothèse auditive selon la revendication 9 et un chargeur conçu pour charger la batterie rechargeable de la prothèse auditive.

11. Système de traitement de données comprenant un processeur et un moyen de code de programme pour amener le processeur à réaliser toutes les étapes du procédé selon l'une quelconque des revendications 1 à 8.

12. Programme informatique comprenant des instructions qui, lorsque le programme est exécuté par un ordinateur, amènent l'ordinateur à effectuer le procédé selon l'une quelconque des revendications 1 à 8.
